(19) **Europäisches Patentamt European Patent Office Office européen des brevets**

(11) **EP 4 723 410 A1**

(12) **EUROPEAN PATENT APPLICATION**

(43) Date of publication:
08.04.2026 Bulletin 2026/15

(51) International Patent Classification (IPC):
$H02H\ 3/093^{(2006.01)}$ $\qquad$ $H02H\ 3/00^{(2006.01)}$
$G01R\ 19/02^{(2006.01)}$ $\qquad$ $G01R\ 19/25^{(2006.01)}$

(21) Application number: 25165891.0

(52) Cooperative Patent Classification (CPC):
H02H 3/0935; H02H 3/006

(22) Date of filing: 25.03.2025

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: 07.10.2024 TW 113138097

(71) Applicant: PowerX Semiconductor Corporation
Zhubei City Hsinchu County 302 (TW)

(72) Inventors:
• **Wang, Kuo-Jeng**
**302 Hsinchu County (TW)**
• **Tu, Hao-Chun**
**302 Hsinchu County (TW)**
• **Huang, Wen-Ren**
**302 Hsinchu County (TW)**

(74) Representative: **Straus, Alexander**
**2K Patentanwälte - München**
**Bajuwarenring 14**
**82041 Oberhaching (DE)**

(54) **CONTROL METHOD AND CONTROL DEVICE FOR ELECTRONIC FUSES**

(57) A control method (30) for an electronic fuse (26) includes detecting current (Ir) passing through the electronic fuse (26) regularly at a time interval (302); storing a plurality of current values detected at a plurality of time points (304); determining a plurality of trip currents corresponding to a plurality of trip times based on the plurality of current values (306), including dividing the plurality of trip currents into two portions for determination, where the first portion is obtained by performing arith- metic averaging operations on the stored current values, and the second portion is obtained by performing arithmetic averaging operations on the current and previously calculated trip currents; comparing the plurality of trip currents with current values corresponding to the plurality of trip times in a trip current versus trip time curve, to generate a plurality of comparison results (308) for controlling a state of the electronic fuse (310).

FIG. 2

EP 4 723 410 A1

## Description

### Field of the Invention

The present invention relates to a control method and control device for an electronic fuse, and more particularly, to a control method and control device capable of enhancing computational efficiency and lowering resource requirements for the electronic fuse.

### Background of the Invention

The electronic fuse (eFuse) plays an important role in modern electronic systems, particularly in automotive electronics, power management, and industrial control fields. Unlike traditional fuses that permanently disconnect when detecting overcurrent, the electronic fuse can achieve resettable overcurrent protection through control circuits.

The most basic control method for the electronic fuse uses fixed-threshold comparators. When a detected current exceeds a preset threshold, the control circuit immediately shuts off the current. This method is simple and direct, but cannot handle short-duration current pulses or long-term low-intensity overloads. To address this issue, the prior art has introduced time-delay mechanisms that use fixed time windows to accumulate current values, triggering protection if the average current within the window exceeds the threshold. While this approach improved the anti-interference ability of the system, it remains difficult to adapt to overcurrent situations across different time scales.

More complex control methods adopt variable time windows or multi-level protection thresholds, attempting to mimic the current-time curve of traditional fuses to provide more precise protection across different time scales. However, these methods typically require significant computational resources and complex hardware circuits, increasing system cost and power consumption.

Furthermore, the existing electronic fuse control methods are mostly based on fixed protection parameters. In practical applications, working environments and load characteristics of the electronic systems may change. For example, in automotive applications, different wire harnesses may have different ignition characteristics that can change over time, making fixed-parameter control methods difficult to adapt to such dynamically changing environments.

Therefore, a key industry goal is to develop an electronic fuse control method that can provide precise overcurrent protection across various time scales, with high computational efficiency, low resource requirements, strong flexibility, and the ability to adaptively adjust based on actual usage conditions.

### Summary of the Invention

This in mind, the present invention aims at providing a control method and control device for an electronic fuse to enhance computational efficiency and lower resource requirements.

This is achieved by a control method and control device for an electronic fuse according to the independent claims. The dependent claims pertain to corresponding further developments and improvements.

As will be seen more clearly from the detailed description following below, a claimed control method for an electronic fuse comprises detecting current passing through the electronic fuse regularly at a time interval; storing a plurality of current values detected at a plurality of time points; determining a plurality of trip currents corresponding to a plurality of trip time based on the plurality of current values, wherein there is an exponential relationship between the plurality of trip time and the time interval, comprising (a) for trip time within the plurality of trip time that are less than or equal to a first value, performing a plurality of arithmetic mean operations on the plurality of current values according to the exponential relationship between each trip time and the time interval, to obtain a first portion of trip currents corresponding to a current time point in the plurality of trip currents; (b) for trip time within the plurality of trip time that are greater than the first value, based on a second value, selecting a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents; and (c) outputting the first portion of trip currents and the second portion of trip currents as the plurality of trip currents; comparing the plurality of trip currents with preset current values corresponding to the plurality of trip time in a preset trip current versus trip time curve, to generate a plurality of comparison results; and controlling a state of the electronic fuse based on the plurality of comparison results.

In another aspect a claimed control device for an electronic fuse comprises a detection module configured to detect current passing through the electronic fuse regularly at a time interval; a storage module, coupled to the detection module, configured to store a plurality of current values detected by the detection module at a plurality of time points; a trip current determination module, coupled to the storage module, configured to determine a plurality of trip currents corresponding to a plurality of trip time based on the plurality of current values, wherein there is an exponential relationship between the plurality of trip time and the time interval, and the trip current determination module performs the following steps to determine the plurality of trip currents (a) for trip time within the plurality of trip time that are less than or equal to a first value, performing a plurality of arithmetic mean operations on the plurality of current values according to the exponential relationship between each trip time and the time interval, to obtain a first portion of trip currents corresponding to a current time point in the plurality of trip currents; (b) for trip time within the plurality of trip time that are greater than the first value, based on a second value, selecting a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents; and (c) outputting the first portion of trip currents and the second portion of trip currents as the plurality of trip currents; a plurality of comparators, coupled to the trip current determination module, respectively configured to compare the plurality of trip currents with preset current values corresponding to the plurality of trip time in a preset trip current versus trip time curve, to generate a plurality of comparison results; and a switch module, coupled to the plurality of comparators, configured to control the state of the electronic fuse based on the comparison results of the plurality of comparators.

**Brief Description of the Drawings**

FIG. 1 is a schematic diagram of a trip current versus trip time curve for a fuse.
FIG. 2 is a schematic diagram of a power transmission system according to one embodiment of the present invention.
FIG. 3 is a schematic diagram of a control flow according to an embodiment of the present invention.
FIG. 4 is a schematic diagram of a determination flow according to an embodiment of the present invention.
FIG. 5 is a schematic diagram of determining trip currents according to an embodiment of the present invention.
FIG. 6 is a schematic diagram of a control device according to an embodiment of the present invention.
FIG. 7 is a schematic diagram of a power transmission system according to another embodiment of the present invention.

**Detailed Description**

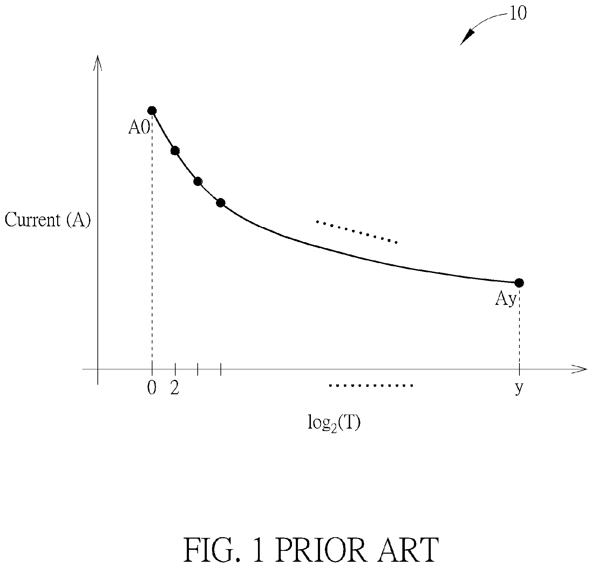

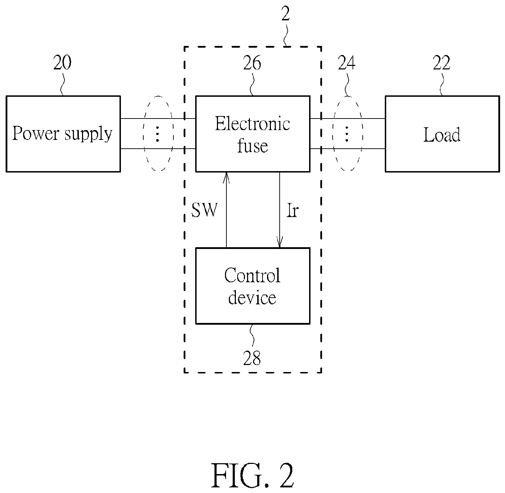

Please refer to FIG. 1, which is a schematic diagram of a trip curve 10 representing a trip current versus trip time curve for a fuse. FIG. 1 is a logarithmic coordinate system that describes the overcurrent conditions the fuse can withstand at different time windows, namely the bearable current at different time windows, where the vertical axis represents the trip currents, and the horizontal axis represents the logarithm (base 2) of trip times T, i.e., $\log_2(T)$. For example, A0 indicates the average current value the fuse can withstand within a trip time T of ($2°=$) 1 millisecond (ms) . If a current exceeding the average current value A0 passes through the fuse within 1 millisecond, the fuse will blow. Similarly, Ay represents the average current value the fuse can withstand within a trip time T of $2^y$ milliseconds. If a current exceeding the average current value Ay passes through the fuse within $2^y$ milliseconds, the fuse will blow. In other words, large currents in a short time will cause rapid fuse blowing, while smaller overcurrents can be sustained for longer periods, thereby avoiding unnecessary fuse blowing caused by short-time pulse currents and ensuring that accumulated thermal energy from long-time lower currents can effectively cause fuse blowing.
From the trip curve 10 in FIG. 1, it can be understood that a fuse needs different blowing characteristics in response to different trip times (time windows) to provide more precise protection at different time scales. Implementing the trip current versus trip time curve of FIG. 1 with an electronic fuse would require massive computational resources and complex hardware circuits. In this regard, the present invention utilizes a dual-mode determination process to determine trip currents, thereby reducing computational resource requirements and circuit complexity. Please refer to FIG. 2, which is a schematic diagram of a power transmission system 2 according to one embodiment of the present invention. The power transmission system 2 transmits power from a power supply 20 to a load 22 via a harness 24, and includes an electronic fuse 26 and a control device 28. The power supply 20 may be a linear power supply, switching mode power supply, programmable power supply, high-voltage power supply, battery supply, etc., and is not limited thereto. The load 22 may be any hardware device powered by the power supply, for example, in the automotive field, the load 22 may be headlights, air conditioning system, electric windows, windshield wipers, etc., and is not limited thereto. The electronic fuse 26 is electrically connected between the power supply 20 and the harness 24, may have different shut-off characteristics corresponding to different trip times, and may be restored to conductivity through reset. The control device 28 is electrically connected to the electronic fuse 26, used to output a switching signal SW based on a current Ir passing through the electronic fuse 26, to control the state of the electronic fuse 26, making its operating characteristics approach or reach the trip curve 10 shown in FIG. 1. In the embodiment of the present invention, the abovementioned "controlling the state of the electronic fuse 26" means controlling the electronic fuse 26 to be in a conductive or shut-off state. In other words, the control device 28 outputs a switching signal SW to turn on or off the electronic fuse 26 based on the current Ir.

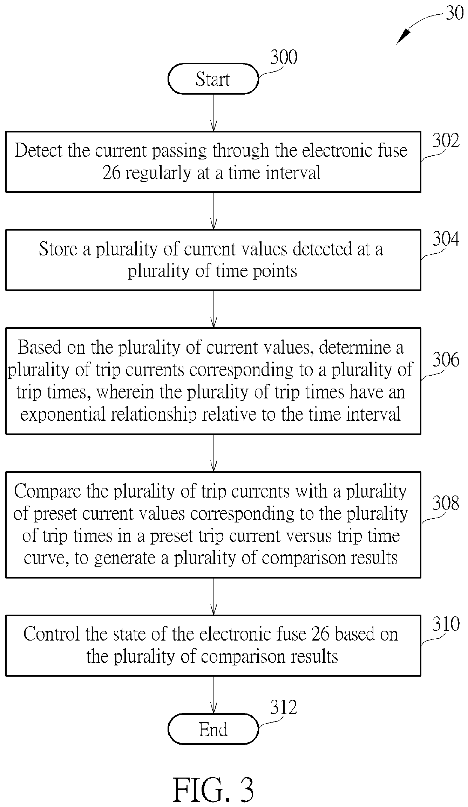

Specifically, the operation of the control device 28 can be summarized as a control flow 30, as shown in FIG. 3. The control flow 30 includes the following steps:

Step 300: Start.

Step 302: Detect the current passing through the electronic fuse 26 regularly at a time interval.

Step 304: Store a plurality of current values detected at a plurality of time points.

Step 306: Based on the plurality of current values, determine a plurality of trip currents corresponding to a plurality of trip times, wherein there is an exponential relationship between the plurality of trip times and the time interval.

Step 308: Compare the plurality of trip currents with a plurality of preset current values corresponding to the plurality of trip times in a preset trip current versus trip time curve (hereinafter referred to as a preset trip curve), to generate a plurality of comparison results.

Step 310: Control the state of the electronic fuse 26 based on the plurality of comparison results.

Step 312: End.

According to the control flow 30, the control device 28 detects or samples the current passing through the electronic fuse 26 at a fixed time interval (Step 302), and stores the detected or sampled current values to form a set of current data corresponding to a plurality of time points (Step 304). The time interval is preferably the response time of the electronic fuse 26, such as 1 millisecond, and the method of storing detected current values can be a shift register method, where the most recently sampled current values replace the oldest current values, but is not limited to this. Next, the control device 28 determines the trip currents corresponding to the plurality of trip times based on the stored current values (Step 306). Notably, there is an exponential relationship between the trip times and the time interval of detection. After obtaining data of the trip currents, the control device 28 compares the data with the corresponding preset current values on the preset trip curve (Step 308). Specifically, the control device 28 compares the actually measured trip currents with the current values corresponding to the same trip times on the preset trip curve, thereby obtaining a plurality of comparison results corresponding to the plurality of trip times. In the embodiment of the present invention, the preset trip curve may be determined based on the characteristics of the harness 24 (e.g., ignition characteristics). Finally, the control device 28 decides how to control the state of the electronic fuse 26 based on the comparison results (Step 310). The preset trip curve is set based on the application scenario, such as the ignition characteristics of the harness 24 or the over-temperature protection characteristics of the electronic fuse 26. Therefore, if a comparison result shows that a trip current is greater than a corresponding current value on the preset trip curve, it indicates that the current current may cause the harness 24 to ignite or the electronic fuse 26 to enter over-temperature protection, so the control device 28 can shut off the electronic fuse 26 to avoid the harness 24 from overheating or the electronic fuse 26 from overload.

In one embodiment, the current passing through the electronic fuse 26 is detected by the control device 28. In another embodiment, the electronic fuse 26 detects the current passing through the electronic fuse 26 through an internal sensing element and generates a corresponding sensing current signal, and the control device 28 samples the sensing current signal to obtain the current values representing the current passing through the electronic fuse 26.

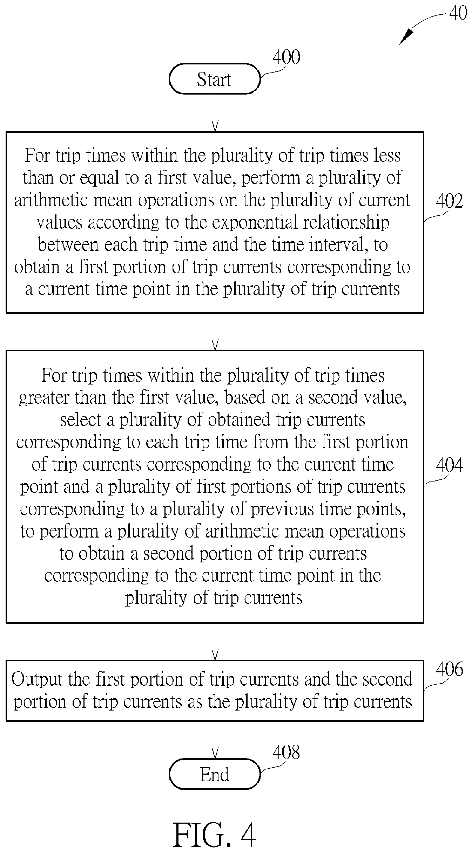

Since there is an exponential relationship between the trip times corresponding to each trip current and the response time of the electronic fuse 26, the control device 28 may control the electronic fuse 26 to respond to large currents in shorter trip times and to accumulated heat from smaller currents in longer trip times. In other words, the control device 28 needs to calculate the trip currents for different trip times based on long-time current detection results. In this case, to reduce computational resources and storage capacity requirements, the embodiment of the present invention further adopts a determination flow 40 to implement Step 306. As shown in FIG. 4, the determination flow 40 includes the following steps:

Step 400: Start.

Step 402: For trip times within the plurality of trip times less than or equal to a first value, perform a plurality of arithmetic mean operations on the plurality of current values according to the exponential relationship between each trip time and the time interval, to obtain a first portion of trip currents corresponding to a current time point in the plurality of trip currents.

Step 404: For trip times within the plurality of trip times greater than the first value, based on a second value, select a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents.

Step 406: Output the first portion of trip currents and the second portion of trip currents as the plurality of trip currents.

Step 408: End.

In short, the determination flow 40 divides the trip currents into two parts for determination. The first part corresponds to trip times less than or equal to the first value, which is obtained by performing arithmetic mean operations on the stored current values based on the exponential relationship between each trip time and the time interval (Step 402). The second part corresponds to trip times greater than the first value, which is obtained by performing arithmetic mean operations on the current and previously calculated (via Step 402) trip currents using the second value (Step 404). In other words, the arithmetic mean operation basis for the first portion of trip currents changes based on the exponential relationship of trip times, while the arithmetic mean operation basis (i.e., the second value) for the second portion of trip currents does not change with trip times and can be a fixed value. In such a situation, computational complexity and cost can be significantly reduced, especially as trip times increase, the computational complexity and cost that the embodiment can reduce become more apparent.

Specifically, let $S_a(x)$ represent the a-th current value stored (or sampled) by the control device 28 at the x-th time interval from the current time point (t0), and $C_T(x)$ represent the trip current at the x-th time interval from the current time point with a trip time of T. For example, $S_1(1), S_2(1), ... , S_{64}(1)$ represent the first to 64th current values which have been stored (or sampled) by the control device 28 at the first time interval from the current time point. Since the control device 28 replaces the oldest current value data with the most recently sampled data each time, in the next (latest) sampling, the previously sampled $S_{64}(1)$ will be removed, the previous $S_{63}(1)$ becomes the new $S_{64}(1)$, the previous $S_{62}(1)$ becomes the new $S_{63}(1)$, and so on, with the previous $S_1(1)$ becoming the new $S_2(1)$, and the most recently sampled current value becoming the new $S_1(1)$. The first value relates to or depends on the number of current values the control device 28 can store (or sample), while the second value relates to the number of trip currents within the first portion of trip currents to be referenced when calculating the second portion of trip currents. The first and second values can be equal, related, or different. For simplicity, assuming the first and second values are equal at $2^p$, according to Step 402, the first portion of trip currents $C_2n(x)$ is:

$$C_{2^n}(x) = \frac{\sum_{a=1}^{2^n} S_a(x)}{2^n} \quad (\text{Eq. 1}),$$

where $n \leq p$, x = 1. And, according to Step 404, the second portion of trip currents $C_2m(x)$ is:

$$C_{2^m}(x) = \frac{\sum_{x=1}^{2^p} C_{2(m-p)}(x)}{2^p} \quad (\text{Eq. 2}),$$

where p < m.

For example, with 17 trip time and a sampling time interval of 1 millisecond (ms), i.e., $T = 2^0, 2^1, 2^2, ... , 2^{16}$ (ms), assuming the control device 28 can store 64 current values, the current values stored by the control device 28 at the first time interval from the current time point are $S_1(1), S_2(1), ... , S_{64}(1)$, with the first value $2^p = 64$, or p = 6. According to Eq. 1, the first portion of trip currents $C_{2^0}(1), C_{2^1}(1), C_{2^2}(1), ..., C_{2^6}(1)$ can be obtained as follows:

$$T = 2^0, n = 0, C_{2^0}(1) = S_1(1);$$

$$T = 2^1, n = 1, C_{2^1}(1) = \frac{S_1(1)+S_2(1)}{2};$$

$$T = 2^2, n = 2, C_{2^2}(1) = \frac{S_1(1)+S_2(1)+S_3(1)+S_4(1)}{4};$$

$$T = 2^6, n = 6, C_{2^6}(1) = \frac{S_1(1)+S_2(1)...S_{64}(1)}{64}.$$

Specifically, for trip times T less than or equal to the first value $2^p$, namely $T = 2^0, 2^1, 2^2, ... , 2^6$, **Eq.** 1 or Step 402 determines the number of current values to calculate the trip currents corresponding to each trip time based on the exponential relationship (i.e., $2^n$) between trip times and time intervals. For example, when calculating $C_{2^1}(1)$, the number of referenced current values is 2; when calculating $C_{2^2}(1)$, the number of referenced current values is 4. Next, Eq. 1 or Step 402 selects current values corresponding to the determined number of current values for each trip time from stored current values (i.e., $S_1(1), S_2(1), ... , S_{64}(1)$). For example, when calculating $C_{2^1}(1)$, $S_1(1)$ and $S_2(1)$ are selected; when calculating $C_{2^2}(1)$, $S_1(1), S_2(1), S_3(1)$ and $S_4(1)$ are selected. Arithmetic mean operations are then performed on these selected current values. For instance, $C_{2^1}(1) = \frac{S_1(1)+S_2(1)}{2}$ , $C_{2^2}(1) = \frac{S_1(1)+S_2(1)+S_3(1)+S_4(1)}{4}$ . Accordingly, the first portion of trip currents $C_{2^0}(1),C_{2^1}(1),C_{2^2}(1),...,C_{2^6}(1)$ corresponding to the current time point is obtained. Additionally, since, for each sampling operation, the most recently sampled data replaces the oldest current value data, when selecting current values to calculate trip currents, it can be understood as selecting the current values starting from the current time point and moving towards previous time points to meet the determined number of current values. For example, when calculating $C_{2^2}(1)$ and requiring 4 referenced current values, Eq. 1 or Step 402 selects 4 current values starting from the current time point (corresponding to $S_1(1)$) and moving to previous time points (corresponding to $S_2(1)$, $S_3(1)$, $S_4(1)$), to meet the determined number of current values (i.e., 4).

After completing the calculation of the first portion of trip currents, Eq. 2 or Step 404 then calculates the second portion of trip currents. In this example, 17 trip time points are required, with $6 < m < 17$. According to Eq. 2, the second portion of trip currents $C_{2^7}(1),C_{2^8}(1),C_{2^9}(1),...,C_{2^{16}}(1)$ can be obtained as follows:

$$T = 2^7, \quad m = 7, \quad C_{2^7}(1) = \frac{\sum_{x=1}^{2^6} C_{2^1}(x)}{2^6} = \frac{C_{2^1}(1)+C_{2^1}(2)+\cdots+C_{2^1}(64)}{64};$$

$$T = 2^8, \quad m = 8, \quad C_{2^8}(1) = \frac{\sum_{x=1}^{2^6} C_{2^2}(x)}{2^6} = \frac{C_{2^2}(1)+C_{2^2}(2)+\cdots+C_{2^2}(64)}{64};$$

$$T = 2^{16}, \quad m = 16, \quad C_{2^{16}}(1) = \frac{\sum_{x=1}^{2^6} C_{2^{10}}(x)}{2^6} = \frac{C_{2^{10}}(1)+C_{2^{10}}(2)+\cdots+C_{2^{10}}(64)}{64}.$$

Specifically, for trip times T greater than the first value, namely $T = 2^7, 2^8, 2^9, ... , 2^{16}$, Eq. 2 or Step 404 respectively obtains a plurality of obtained trip currents corresponding to each trip time and related to the second value (i.e., $2^p$) from the first portion of trip currents corresponding to the current time point (i.e., $x = 1$) and the plurality of first portions of trip currents corresponding to the plurality of previous time points (i.e., $x = 2,3, ... ,64$) based on a difference (i.e., $2^{(m-p)}$) between each trip time (i.e., $2^m$) and the first value $2^p$. Next, Eq. 2 or Step 404 performs arithmetic mean operations on the obtained trip currents corresponding to each trip time and related to the second value to obtain the second portion of trip currents. For example, when calculating $C_{2^7}(1)$, $T = 2^7$, the trip time difference relative to the first value $2^6$ is $2^1$, and the first portion of trip currents to be referenced would be $C_{2^1}(x)$. In detail, the calculation of $C_{2^7}(1)$ involves referencing the first portion of trip current corresponding to the current time point, i.e. , $C_{2^1}(1)$ for $x = 1$, and the obtained first portion of trip currents related to the second value $2^6$ , i.e., $C_{2^1}(2)$, $C_{2^1}(3)$, ... , $C_{2^1}(64)$ for $x=2,3,...,64$ . Then, by performing arithmetic mean operations on these trip currents using the second value $2^6$, the trip current $C_{2^7}(1)$ can be obtained. By the same token, the second portion of trip currents $C_{2^7}(1)$, $C_{2^8}(1)$, $C_{2^9}(1)$, ... , $C_{2^{16}}(1)$ can be determined.

It is important to note that in this example, when calculating the second portion of trip currents $C_{2^{13}}(1)$ to $C_{2^{16}}(1)$, **Eq.** 2 or Step 404 references $C_{2^7}(1)$ to $C_{2^{10}}(1)$, which are also within the second portion of trip currents. However, as derived previously, the calculations of $C_{2^7}(1)$ to $C_{2^{10}}(1)$ rely on the first portion of trip currents $C_{2^1}(1)$ to $C_{2^4}(1)$. Therefore, in a broader sense, $C_{2^{13}}(1)$ to $C_{2^{16}}(1)$ within the second portion of trip currents are still calculated by referencing the first portion of trip currents. Therefore, the embodiment of the present invention performs arithmetic mean operations on stored current values to determine the first portion of trip currents, and then performs arithmetic mean operations on the calculated first portion of trip currents to determine the second portion of trip currents, thus completing the calculation of all trip currents for the current time point (Step 406).

As can be known from the above, after determining the number of trip times, the first value is related to the proportion of the first portion of trip currents and the second portion of trip currents. For instance, in the abovementioned embodiments, with 17 trip time points and the first value of $2^6$, the first portion of trip currents corresponds to trip times $2^0$ to $2^6$, while the second portion of trip currents corresponds to trip times $2^7$ to $2^{16}$. Meanwhile, the first value is also related to the number of current values referenced when calculating the first portion of trip currents, which is $S_1(1), S_2(1), ... , S_{64}(1)$ in the above example. In such a situation, those skilled in the art may determine the first value based on system requirements, such as determining the first value according to the storage space of the control device 28, or first determining the first value and then designing or adjusting the storage space of the control device 28. Moreover, as can be known from Eq. 1, when calculating the first portion of trip currents, the basis $2^n$ for the arithmetic mean of each trip current changes with the trip time. For example, when calculating $C_{2^1}(1)$, the arithmetic mean basis is 2, and when calculating $C_{2^2}(1)$, the arithmetic mean basis is 4. Therefore, when determining the first value, those skilled in the art should also consider that as the trip currents increase, the computational requirements of the control device 28 will increase exponentially.

On the other hand, from Eq. 2, when calculating the second portion of trip currents, the first value ($2^p$ in the numerator $C_{2^{(m-p)}}(X)$ of Eq. 2) determines which trip currents within the first portion of trip currents need to be referenced for each trip time, while the second value ($2^p$ in the summation symbol of the numerator and $2^p$ in the denominator of Eq. 2) determines the arithmetic mean basis and the number of trip currents within the first portion of (current and previous) trip currents to be referenced. For instance, when calculating $C_{27}(1)$, based on the difference between the trip time and the first value, i.e., $2^{(m-p)}=2^1$, the first portion of trip currents to be referenced is $C_{21}(x)$, and based on the second value, the trip currents to be referenced within $C_{21}(x)$ are $C_{21}(1)$, $C_{21}(2)$, ... , $C_{21}(64)$, and the arithmetic mean basis is 64. Furthermore, a closer examination of Eq. 2 reveals that the calculations for all the second portion of trip currents use 64 as the arithmetic mean basis. In other words, different from the calculations for the first portion of trip currents, where the arithmetic mean basis $2^n$ changes with the trip time, the embodiment of the present invention uses a consistent arithmetic mean basis for calculating all the second portion of trip currents. As a result, the embodiment of the present invention ensures that the computational resources required for the second portion of trip currents increase linearly with the trip time, effectively reducing computational demands.

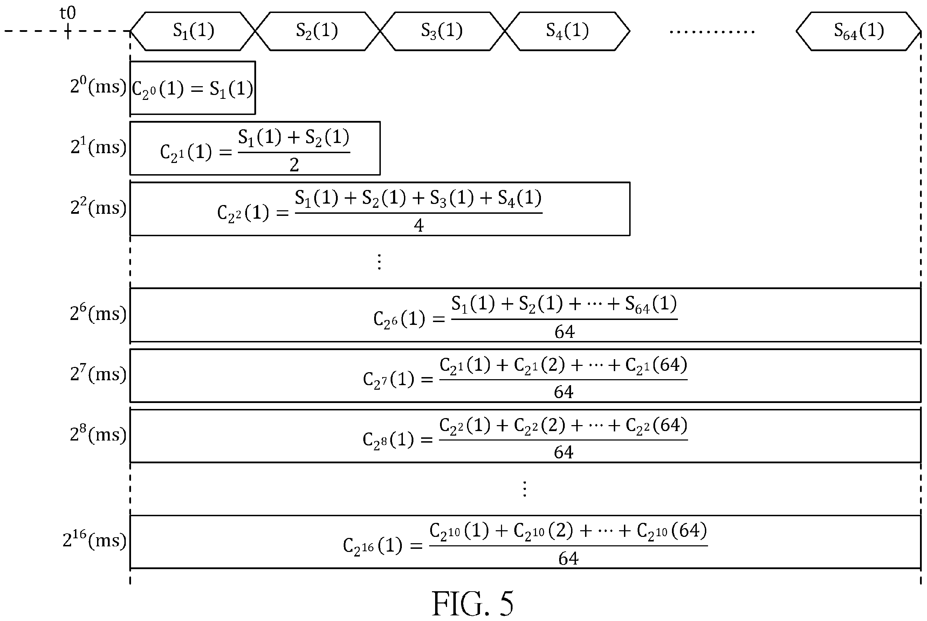

The aforementioned calculation and derivation process can be visualized as shown in Fig. 5, which clearly illustrates that the arithmetic mean basis for calculating the first portion of trip currents changes with the trip time, while the arithmetic mean basis for calculating the second portion of trip currents remains fixed.

Notably, the determination flow 40 in FIG. 4 represents an embodiment of the present invention, and those skilled in the art may make different modifications accordingly. For example, in addition to appropriately adjusting the first value based on system requirements, the second value may differ from the first value or be dynamically adjusted. In one embodiment, the control device 28 may adjust the second value based on variations in computational resources. Furthermore, while the aforementioned embodiments divide the trip currents to be calculated into two portions, it is also possible to divide the trip currents to be calculated into three or more portions. For instance, a third portion of the trip currents could be set to use a different second value, or the third portion could be defined as using the second portion of trip currents as a calculation basis, all of which fall within the scope of the present invention.

By utilizing the determination flow 40 or Eq. 1 and Eq. 2, the embodiment of the present invention may divide the trip currents into two or more portions for computation. The first portion involves arithmetic mean operation of stored (sampled) current values, while the second portion performs arithmetic mean operation based on computation results of the first portion. Simultaneously, the calculation basis for the first portion of trip currents changes according to the trip time, whereas the calculation basis for the second portion of trip currents does not change with trip time, thereby significantly reducing computational complexity and cost. Moreover, there is an exponential relationship between the trip times and the sampling time interval, meaning that determination of trip currents becomes more frequent closer to the current time point, which ensures simultaneous responsiveness to both short-duration high currents and long-duration smaller currents, thereby avoiding unnecessary shutdown of the electronic fuse 26 due to short-duration pulse currents and preventing damage to the harness 24 or overloading of the electronic fuse 26.

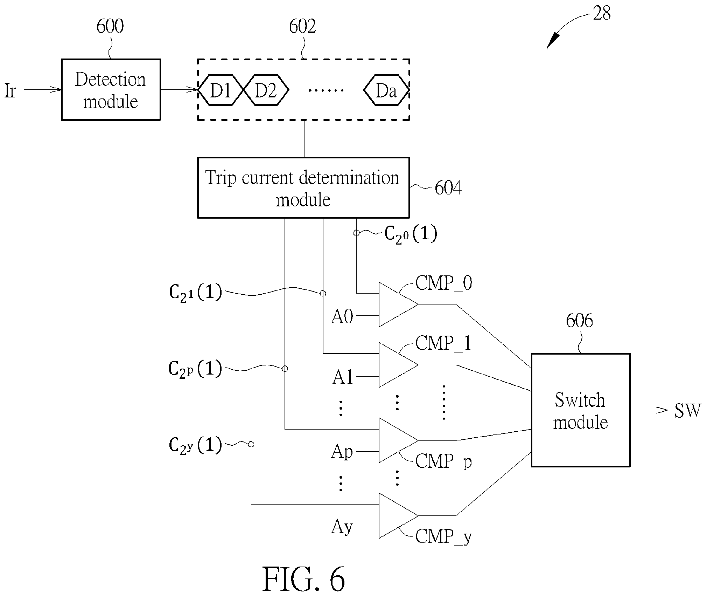

After completing trip current determination through the determination flow 40 or Eq. 1 and Eq. 2, returning to the control flow 30, the control device 28 can compare the determined trip currents with the preset current values in the preset trip curve (Step 308), and accordingly control the state of the electronic fuse 26 (Step 310). Through the control flow 30, the control device 28 can control the electronic fuse 26 to be conducted or shut off based on the current passing through the electronic fuse 26, thus preventing burnout of the harness 24 or damage to the electronic fuse 26. It should be noted that the power transmission system 2 in FIG. 2 is an embodiment of the present invention, and those skilled in the art can make different modifications accordingly. For example, please refer to FIG. 6, which is a schematic diagram of an embodiment of the control device 28. The control device 28 comprises a detection module 600, a storage module 602, a trip current determination module 604, comparators CMP_0 to CMP_y, and a switch module 606. In this embodiment, the detection module 600 is configured to detect the current Ir passing through the electronic fuse 26 regularly at a time interval, which may be implemented through a combination of one or more resistors and one or more analog-to-digital converters. The resistor can convert the current into a voltage signal, while the analog-to-digital converter can perform sampling to convert the sampled signals into digital current values. In alternative embodiments, the electronic fuse 26 may utilize an internal sensing element to detect the current passing through it and generate a corresponding sensing current signal, and the detection module 600 may then sample the sensing current signal at a time interval to obtain the current values representing the current through the electronic fuse 26. The storage module 602 is coupled to the detection module 600, and includes storage units D1 to Da, which preferably store the current values detected by the detection module 600 at a plurality of time points using a shift register method, i.e., each sampling replaces the oldest current value data with the most recently sampled current value data. The trip current determination module 604 is coupled to the storage module 602 and determines a plurality of trip currents $C_T(x)$ corresponding to a plurality of trip times based on the current values stored in the storage module 602. Specifically, the trip current determination module 604 can execute the determination flow 40 or Eq. 1 and Eq. 2 and their derivative variations, meaning dividing the trip currents into two or more portions for computation. The first portion involves arithmetic mean operation of the current values stored in the storage module 602, while the second portion performs arithmetic mean operation based on the computation results of the first portion. The comparators CMP_0 to CMP_y are coupled to the trip current determination module 604 and used to compare each trip current $C_T(x)$ with the corresponding preset current values A0 to Ay corresponding to each trip time in the preset trip curve, so as to generate corresponding comparison results. The switch module 606 is coupled to the comparators CMP_0 to CMP_y, and configured to output a switching signal SW to control the state of the electronic fuse 26 based on the comparison results of the comparators CMP_0 to CMP_y.

In one embodiment, when the electronic fuse 26 is in a conducted state, if the comparison result of any of the comparators CMP_0 to CMP_y indicates that its corresponding trip current exceeds the corresponding preset current value in the preset trip curve, the switch module 606 outputs a switching signal SW to control the electronic fuse 26 to enter a shut-off state. For example, if the comparison result of the comparator CMP_1 indicates that the trip current $C_{21}(1)$ exceeds the preset current value Ap, the switch module 606 outputs the switching signal SW to control the electronic fuse 26 to enter a shut-off state. As can be seen, the condition for controlling the electronic fuse 26 to enter a shut-off state is that the number of comparison results indicating the trip currents exceed the corresponding preset current values in the preset trip curve is equal to 1.

The detailed operations of the trip current determination module 604 can be referenced in the previous description of the determination flow 40 and Eq. 1, Eq. 2. It should be noted that the first value $2^p$ may be related to the number **"a"** of storage units D1 to Da, and the number **"y"** of comparators CMP_0 to CMP_y is related to the trip current versus trip time curve. Therefore, designers may appropriately adjust the implementation of the control device 28 according to system requirements, without being limited thereto.

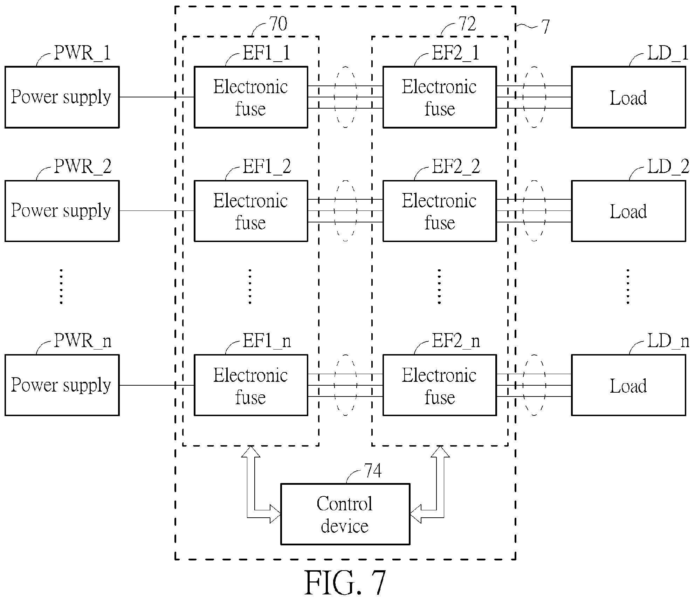

Additionally, the power transmission system 2 shown in FIG. 2 only includes a single electronic fuse. However, those skilled in the art can appropriately derive multiple electronic fuses and potentially share certain components. For example, please refer to FIG. 7, which is a schematic diagram of a power transmission system 7 according to an embodiment of the present invention. The power transmission system 7 is utilized to transmit power from power supplies PWR_1 to PWR_n to loads LD_1 to LD_n, and comprises an input protection module 70, an output protection module 72, and a control device 74. The power supplies PWR_1 to PWR_n may include linear power supplies, switched-mode power supplies, programmable power supplies, high-voltage power supplies, battery supplies, and are not limited to these examples. The loads LD_1 to LD_n may be any hardware devices powered by the power supplies. For instance, in an automotive application, the loads LD_1 to LD_n could include vehicle lights, air conditioning systems, electric windows, windshield wipers, etc. The input protection module 70 and the output protection module 72 constitute the power transmission network from the power supplies PWR_1 to PWR_n to the loads LD_1 to LD_n, which are composed of electronic fuses EF1_1 to EF1_n and EF2_1 to EF2_n, respectively. The electronic fuses EF1_1 to EF1_n and EF2_1 to EF2_n can have different shutdown characteristics corresponding to different trip times and can be restored to a conducted state through reset. The control device 74 is electrically connected to the electronic fuses EF1_1 to EF1_n and EF2_1 to EF2_n, and configured to control the states of the electronic fuses EF1_1 to EF1_n and EF2_1 to EF2_n (i.e., maintaining each electronic fuse in either a conducted or shut-off state) based on the currents passing through the electronic fuses EF1_1 to EF1_n and EF2_1. The control method of the control device 74 for each electronic fuse can reference the previous description of the control device 28, thereby achieving or approaching the trip current versus trip time curve shown in FIG. 1.

The power transmission system 7 in FIG. 7 can implement a power network, such as a Power Distribution Module (PDM) in an automotive context. When applied to automotive systems, the control device 74 of the present invention can appropriately shut off specific electronic fuses to prevent overheating of the corresponding harness or electronic fuse overload. Furthermore, for automotive applications, in addition to appropriately calculating trip currents, it is necessary to consider how the usage environment might affect the harness characteristics. In such cases, the trip current versus trip time curve (such as the aforementioned preset trip curve) may be updated to meet actual usage requirements.

In detail, with the continuous advancement of automotive technology, the complexity of vehicle electronic systems has increased significantly. Traditional harness protection methods can no longer meet the safety requirements of modern vehicles, particularly in dynamically adjusting protection parameters based on harness aging conditions. Generally, the relationship between wire aging speed and temperature can be expressed by the Arrhenius equation:

$$t_{life} = A \times e^{\frac{E_a}{k_b \times T}};$$

where:

$t_{life}$: Expected lifespan of the wire (time);
A: Constant related to material characteristics;
$E_a$: Activation energy (unit: Joules/mole);
$k_b$: Boltzmann constant (1.38 x 10^-23 J/K);
T: Operating temperature of the wire (absolute temperature, Kelvin) .

The equation demonstrates that wire aging is closely correlated with environmental temperature and temperature generated by current flow. Automotive harnesses exposed to high temperatures during driving and intense sunlight during parking present significant aging concerns. To address this, manufacturers can record current values for each load at specific speeds and environmental temperatures after vehicle production. For instance, a PDM microcontroller can record and store such data, which can be returned during periodic vehicle maintenance or uploaded to the manufacturer's server via network, serving as a baseline for future harness or load condition assessments. For example, as vehicle usage progresses, harnesses gradually age due to usage frequency and environmental factors. This aging process reduces the current-carrying capacity of the harnesses and increases safety risks. The embodiment of the present invention can evaluate the harness aging degree based on driving mileage (e.g., 10km/20km/30km) or other relevant parameters, and multiply the preset current values in the trip curve **(e.g.** the preset trip curve in Step 308) used for controlling the electronic fuse by a derating coefficient, to update the trip curve through over-the-air technology or wired connections (such as via Controller Area Network).

It should be noted that to achieve such update operations, the power transmission system 7 should possess wired or wireless connectivity capabilities and appropriately update the trip curve stored in the control device 74. Such derivative variations are within the common knowledge of those skilled in the art and thus need not be elaborated upon.

In short, for automotive applications, the embodiment of the present invention can enhance electronic system safety and reliability by real-time monitoring of harness conditions and dynamically adjusting protection parameters, which not only prevents potential safety hazards but also provides crucial decision-making information for vehicle maintenance.

In summary, in terms of the electronic fuse control method, the prior art has high computational complexity, require substantial hardware resources, and lack flexibility in adapting to dynamic work environments and load characteristics. In contrast, the present invention provides precise overcurrent protection across various time scales, featuring high computational efficiency, low resource requirements, strong flexibility, and the ability to update and adjust based on actual usage conditions.

**Claims**

1. A control method (30) for an electronic fuse (26), **characterized by** comprising:

   detecting a current (Ir) passing through the electronic fuse (26) regularly at a time interval (302);
   storing a plurality of current values detected at a plurality of time points (304);
   determining a plurality of trip currents corresponding to a plurality of trip time based on the plurality of current values, wherein there is an exponential relationship between the plurality of trip time and the time interval (306), comprising:

      (a) for trip time within the plurality of trip time that are less than or equal to a first value, performing a plurality of arithmetic mean operations on the plurality of current values according to the exponential relationship between each trip time and the time interval, to obtain a first portion of trip currents corresponding to a current time point in the plurality of trip currents (402);
      (b) for trip time within the plurality of trip time that are greater than the first value, based on a second value, selecting a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents (404); and
      (c) outputting the first portion of trip currents and the second portion of trip currents as the plurality of trip currents (406);

   comparing the plurality of trip currents with preset current values corresponding to the plurality of trip time in a preset trip current versus trip time curve, to generate a plurality of comparison results (308); and
   controlling a state of the electronic fuse based on the plurality of comparison results (310).

2. A control device (28) for an electronic fuse (26), **characterized by** comprising:

   a detection module (600) configured to detect a current (Ir) passing through the electronic fuse (26) regularly at a time interval;
   a storage module (602), coupled to the detection module (600), configured to store a plurality of current values detected by the detection module (600) at a plurality of time points;
   a trip current determination module (604), coupled to the storage module (602), configured to determine a plurality of trip currents ($C_{21}(1)$ - $C_{2y}(1)$) corresponding to a plurality of trip time based on the plurality of current values, wherein there is an exponential relationship between the plurality of trip time and the time interval, and the trip current determination module performs the following steps to determine the plurality of trip currents:

(a) for trip time within the plurality of trip time that are less than or equal to a first value, performing a plurality of arithmetic mean operations on the plurality of current values according to the exponential relationship between each trip time and the time interval, to obtain a first portion of trip currents corresponding to a current time point in the plurality of trip currents (402);

(b) for trip time within the plurality of trip time that are greater than the first value, based on a second value, selecting a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents (404); and

(c) outputting the first portion of trip currents and the second portion of trip currents as the plurality of trip currents (406);

a plurality of comparators (CMP_0 to CMP_y), coupled to the trip current determination module (604), respectively configured to compare the plurality of trip currents ($C_{21}(1)$ to $C_{2y}(1)$) with preset current values (A0 to Ay) corresponding to the plurality of trip time in a preset trip current versus trip time curve, to generate a plurality of comparison results; and

a switch module (606), coupled to the plurality of comparators (CMP_0 to CMP_y), configured to control the state of the electronic fuse (26) based on the comparison results of the plurality of comparators.

3. The control method (30) of claim 1 or the control device (28) of claim 2, **characterized in that** the first value is related to a number of the plurality of current values.

4. The control method (30) of claim 1 or the control device (28) of claim 2, **characterized in that** the step (a) comprises:

for trip time within the plurality of trip time that are less than or equal to the first value, determining a number of current values to be used for calculating trip currents corresponding to each trip time based on the exponential relationship between each trip time and the time interval; and

selecting current values corresponding to the number of current values for each trip time from the plurality of current values, and performing an arithmetic mean operation respectively on the selected current values, to obtain the first portion of trip currents corresponding to the current time point.

5. The control method (30) or the control device (28) of claim 4, **characterized in that** selecting the current values corresponding to the number of current values for each trip time from the plurality of current values is selecting the current values starting from the current time point and moving towards previous time points to meet the number of current values, so as to perform the plurality of arithmetic mean operations, thereby obtaining the first portion of trip currents corresponding to the current time point.

6. The control method (30) of claim 1 or the control device (28) of claim 2, **characterized in that** the step (b) comprises:

for trip time within the plurality of trip time that are greater than the first value, based on a difference between each trip time and the first value, respectively obtaining the plurality of obtained trip currents corresponding to each trip time and related to the second value from the first portion of trip currents corresponding to the current time point and the plurality of first portions of trip currents corresponding to the plurality of previous time points; and

performing an arithmetic mean operation on the plurality of obtained trip currents corresponding to each trip time and related to the second value by the second value to obtain the second portion of trip currents.

7. The control method (30) of claim 1, **characterized by** further comprising adjusting the second value.

8. The control method (30) of claim 1, **characterized by** further comprising adjusting the first value to adjust the number of trip currents comprised in the first portion of trip currents and the second portion of trip currents.

9. The control method (30) of claim 1 or the control device (28) of claim 2, **characterized in that** the electronic fuse (26) is electrically connected to a harness (24), and the preset trip current versus trip time curve is related to an ignition characteristics of the harness (24).

10. The control method (30) of claim 1, **characterized by** further comprising updating the trip current versus trip time curve.

11. The control method (30) of claim 10, **characterized in that** the electronic fuse (26) is electrically connected to a harness (24), and updating the trip current versus trip time curve is based on usage of the harness (24).

12. The control device (28) of claim 2, **characterized in that** the trip current determination module (604) is further configured to adjust the second value.

13. The control device (28) of claim 2, **characterized in that** the trip current determination module (604) is further configured to adjust the first value to adjust the number of trip currents contained in the first portion of trip currents and the second portion of trip currents.

14. The control device (28) of claim 2, **characterized by** further comprising an update module configured to update the trip current versus trip time curve.

15. The control device (28) of claim 14, **characterized in that** the electronic fuse (26) is electrically connected to a harness (24), and the update module updates the trip current versus trip time curve based on the usage of the harness (24).

FIG. 1 PRIOR ART

2

20 26 24 22

| Power supply | : | Electronic fuse | : | Load |

SW    Ir

Control device

28

FIG. 2

_—30_

```
        ⎛ Start ⎞  300
        ⎝        ⎠
             │
             ▼
```

Detect the current passing through the electronic fuse 26 regularly at a time interval — 302

Store a plurality of current values detected at a plurality of time points — 304

Based on the plurality of current values, determine a plurality of trip currents corresponding to a plurality of trip times, wherein the plurality of trip times have an exponential relationship relative to the time interval — 306

Compare the plurality of trip currents with a plurality of preset current values corresponding to the plurality of trip times in a preset trip current versus trip time curve, to generate a plurality of comparison results — 308

Control the state of the electronic fuse 26 based on the plurality of comparison results — 310

```
        ⎛ End ⎞  312
        ⎝      ⎠
```

# FIG. 3

40

```
    ┌─────────┐ 400
    │  Start  │
    └─────────┘
         │
         ▼
┌──────────────────────────────────────────┐
│  For trip times within the plurality of  │
│  trip times less than or equal to a       │  402
│  first value, perform a plurality of      │
│  arithmetic mean operations on the        │
│  plurality of current values according    │
│  to the exponential relationship          │
│  between each trip time and the time      │
│  interval, to obtain a first portion of   │
│  trip currents corresponding to a         │
│  current time point in the plurality of   │
│  trip currents                            │
└──────────────────────────────────────────┘
```

For trip times within the plurality of trip times less than or equal to a first value, perform a plurality of arithmetic mean operations on the plurality of current values according to the exponential relationship between each trip time and the time interval, to obtain a first portion of trip currents corresponding to a current time point in the plurality of trip currents — 402

For trip times within the plurality of trip times greater than the first value, based on a second value, select a plurality of obtained trip currents corresponding to each trip time from the first portion of trip currents corresponding to the current time point and a plurality of first portions of trip currents corresponding to a plurality of previous time points, to perform a plurality of arithmetic mean operations to obtain a second portion of trip currents corresponding to the current time point in the plurality of trip currents — 404

Output the first portion of trip currents and the second portion of trip currents as the plurality of trip currents — 406

End — 408

FIG. 4

EP 4 723 410 A1

t0

$S_1(1)$  $S_2(1)$  $S_3(1)$  $S_4(1)$  ············  $S_{64}(1)$

$2^0$(ms)  $C_{2^0}(1) = S_1(1)$

$2^1$(ms)  $C_{2^1}(1) = \dfrac{S_1(1) + S_2(1)}{2}$

$2^2$(ms)  $C_{2^2}(1) = \dfrac{S_1(1) + S_2(1) + S_3(1) + S_4(1)}{4}$

$\vdots$

$2^6$(ms)  $C_{2^6}(1) = \dfrac{S_1(1) + S_2(1) + \cdots + S_{64}(1)}{64}$

$2^7$(ms)  $C_{2^7}(1) = \dfrac{C_{2^1}(1) + C_{2^1}(2) + \cdots + C_{2^1}(64)}{64}$

$2^8$(ms)  $C_{2^8}(1) = \dfrac{C_{2^2}(1) + C_{2^2}(2) + \cdots + C_{2^2}(64)}{64}$

$\vdots$

$2^{16}$(ms)  $C_{2^{16}}(1) = \dfrac{C_{2^{10}}(1) + C_{2^{10}}(2) + \cdots + C_{2^{10}}(64)}{64}$

FIG. 5

FIG. 6

PWR_1 Power supply
PWR_2 Power supply
PWR_n Power supply

70
EF1_1 Electronic fuse
EF1_2 Electronic fuse
EF1_n Electronic fuse

72
EF2_1 Electronic fuse
EF2_2 Electronic fuse
EF2_n Electronic fuse

7

LD_1 Load
LD_2 Load
LD_n Load

74
Control device

FIG. 7

# EUROPEAN SEARCH REPORT

**Application Number**

EP 25 16 5891

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 644 238 A (SEIFERT GREGORY J [US] ET AL) 1 July 1997 (1997-07-01) * the whole document * | 1-15 | INV. H02H3/093 H02H3/00 G01R19/02 G01R19/25 |
| A | EP 4 175 093 A1 (EATON INTELLIGENT POWER LTD [IE]) 3 May 2023 (2023-05-03) * paragraphs [0001] - [0028]; figures 1-5 * | 1-15 | |
| A | US 2023/187922 A1 (RANDAZZO VINCENZO [IT] ET AL) 15 June 2023 (2023-06-15) * paragraph [0150]; figures 5, 15 * | 1-15 | |
| A | US 11 482 853 B2 (INFINEON TECHNOLOGIES AUSTRIA AG [AT]) 25 October 2022 (2022-10-25) * columns 8-10; figures 1,4, 5 * | 1-15 | |
| A | JP 6 942321 B2 (ISHII ELECTRIC SYSTEM INC) 29 September 2021 (2021-09-29) * paragraphs [0033] - [0060]; figures 1,4-6 * | 1-15 | **TECHNICAL FIELDS SEARCHED (IPC)** H02H G01R |

The present search report has been drawn up for all claims

| Place of search | Date of completion of the search | Examiner |
|---|---|---|
| Munich | 29 July 2025 | Gomes Guerreiro, G |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 ......................................................................

& : member of the same patent family, corresponding
    document

EPO FORM 1503 03.82 (P4C01)

## ANNEX TO THE EUROPEAN SEARCH REPORT
## ON EUROPEAN PATENT APPLICATION NO.

EP 25 16 5891

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2025

| Patent document cited in search report | | Publication date | Patent family member(s) | | Publication date |
|---|---|---|---|---|---|
| US 5644238 | A | 01-07-1997 | NONE | | |
| EP 4175093 | A1 | 03-05-2023 | CN | 116073321 A | 05-05-2023 |
| | | | EP | 4175093 A1 | 03-05-2023 |
| | | | US | 2023133287 A1 | 04-05-2023 |
| US 2023187922 | A1 | 15-06-2023 | NONE | | |
| US 11482853 | B2 | 25-10-2022 | CN | 114079263 A | 22-02-2022 |
| | | | EP | 3958418 A1 | 23-02-2022 |
| | | | US | 2022052601 A1 | 17-02-2022 |
| JP 6942321 | B2 | 29-09-2021 | JP | 6942321 B2 | 29-09-2021 |
| | | | JP | 2020089072 A | 04-06-2020 |

EPO FORM P0459

For more details about this annex : see Official Journal of the European Patent Office, No. 12/82